# EUROPEAN PATENT APPLICATION

(11) **EP 1 691 405 A2**
(43) Date of publication of application: **16.08.2006**
(21) Application number: 06002131.8
(22) Date of filing: 02.02.2006
(51) Int. Cl.: H01L 21/56

(54) **Package or pre-applied foamable underfill for lead-free process**

(30) Priority: 09.02.2005 US 54164
(71) Applicant: National Starch and Chemical Investment Holding Corporation, New Castle, Delaware 19720 (US)
(72) Inventor: Shah, Jayesh, Plaistow New Hampshire 03865 (US)
(74) Representative: Held, Stephan

(57) **Abstract**

A B-stageable or pre-formed film underfill encapsulant composition that is used in the application of lead-free electronic components to substrates. The composition comprises an expandable microsphere, thermoplastic resin, thermoset resin, a latent catalyst, and a solvent. Various other additives, such as adhesion promoters, flow additives and rheology modifiers may also be added as desired. The underfill encapsulant may be dried or B-staged to provide a coating on the substrate or component that is smooth and non-tacky. In an alternative embodiment, the underfill encapsulant is a pre-formed film. In both embodiments the expandable filler material expands upon the application of higher temperatures to form a closed-cell foam structure in the desired portion of the assembly.

## Description

### FIELD OF THE INVENTION

The present invention is related to lead-free underfill encapsulant containing one or more expandable fillers and a method for its application to electronic devices.

### BACKGROUND OF THE INVENTION

This invention relates to underfill encapsulant compounds containing one or more expandable fillers for lead-free reflow process. The encapsulants are used to protect and reinforce the interconnections between an electronic component and a substrate in a microelectronic device. Microelectronic devices contain multiple types of electrical circuit components, mainly transistors assembled together in integrated circuit (IC) chips, but also resistors, capacitors, and other components. These electronic components are interconnected to form the circuits, and eventually are connected to and supported on a carrier or a substrate, such as a printed wire board. The integrated circuit component may comprise a single bare chip, a single encapsulated chip, or an encapsulated package of multiple chips. The single bare chip can be attached to a lead frame, which in turn is encapsulated and attached to the printed wire board, or it can be directly attached to the printed wire board. These chips are originally formed as a semiconductor wafer containing multiple chips. The semiconductor wafer is diced as desired into individual chips or chip packages.

Whether the component is a bare chip connected to a lead frame, or a package connected to a printed wire board or other substrate, the connections are made between electrical terminations on the electronic component and corresponding electrical terminations on the substrate. One method for making these connections uses polymeric or metallic material that is applied in bumps to the component or substrate terminals. The terminals are aligned and contacted together and the resulting assembly is heated to reflow the metallic or polymeric material and solidify the connection.

During its normal service life, the electronic assembly is subjected to cycles of elevated and lowered temperatures. Due to the differences in the coefficient of thermal expansion for the electronic component, the interconnect material, and the substrate, this thermal cycling can stress the components of the assembly and cause it to fail. To prevent the failure, the gap between the component and the substrate is filled with a polymeric encapsulant, hereinafter called underfill or underfill encapsulant, to reinforce the interconnect material and to absorb some of the stress of the thermal cycling. Two prominent uses for underfill technology are for reinforcing packages known in the industry as chip scale packages (CSP), in which a chip package is attached to a substrate, and flip-chip packages in which a chip is attached by an array of interconnections to a substrate. Another function of the underfill is to reinforce the component against mechanical shock such as impact or vibration. This is especially important for durability in portable electronic devices such as cellular telephones and the like that may be expected to be accidentally dropped or otherwise stressed during use.

In conventional capillary flow underfill applications, the underfill dispensing and curing takes place after the reflow of the metallic or polymeric interconnect. In this procedure, flux is initially applied on the metal pads on the substrate. Next, the chip is placed on the fluxed area of the substrate, on top of the soldering site. The assembly is then heated to allow for reflow of the solder joint. At this point, a measured amount of underfill encapsulant material is dispensed along one or more peripheral sides of the electronic assembly and capillary action within the component-to-substrate gap draws the material inward. After the gap is filled, additional underfill encapsulant may be dispensed along the complete assembly periphery to help reduce stress concentrations and prolong the fatigue life of the assembled structure. The underfill encapsulant is subsequently cured to reach its optimized final properties. A drawback of capillary underfill is that its application requires several extra steps and is thus not economical for high volume manufacturing.

Recently, attempts have been made to streamline the process and increase efficiency by the use of no flow underfill and coating the no flow underfill directly on the assembly site before the placement of the component on that site. After the component is placed it is soldered to the metal connections on the substrate by passing the entire assembly through a reflow oven. During the process the underfill fluxes the solder and metal pads to form the interconnect joints between the substrate and the underfill. One limitation of the no flow underfill process is that the substrate and components must be pre-dried to avoid excessive voiding within the underfill that will lead to solder extrusion that ultimately may create a short-circuit to another connection. Thus, the substrates must be dried before assembly and then stored in dry storage. This process is unwieldy for high volume manufacturers.

A recent trend in the electronic devices is a movement towards lead-free solders. Due to various government regulations and environmental concerns, lead-free solders are replacing the traditional eutectic solders. Interconnecting lead-free solder requires a different process than eutectic solder. While the liquidous temperature of eutectic solder is at 183°C, the liquidous temperature of lead-free solder is 217°C or higher. Furthermore, the reflow peak temperature for eutectic solder is at 220°C while the lead-free reflow peak temperature is 245-255°C. Hence, this higher temperature requires different challenges for underfill utilizing the lead-free process.

In order to be useful as a pre-applied underfill encapsulant, the underfill must have several important properties. First, the material must be easy to apply uniformly so that the entire assembly has a consistent coating. The underfill encapsulant must be either B-stageable, which means that the underfill must be solidified after its placement on a CSP component to provide a smooth, non-tacky coating with minimal residual solvent, or capable of being formed into a film. Further, there is often great difficulty during manufacturing in uniformly applying conventional underfill materials.

The B-stage process usually occurs at a temperature lower than about 150°C without prematurely curing the underfill encapsulant. The final curing of the underfill encapsulant must be delayed until after the fluxing of the lead-free solder to form interconnection, which occurs at a temperature around 217°C. The final curing of the underfill should occur rapidly after the solder bump flow and interconnection. During this final attachment of the individual chips to a substrate, the underfill encapsulant must flow in order to enable fillet formation and provide good adhesion between the chip, or chip passivation layer, the substrate, or the solder mask, and the solder joints.

There is no conventional thermoplastic foamable underfill that can withstand the harsh conditions of lead-free reflow profile. Under the lead-free reflow process, the conventional thermoplastic foamable underfill melts and the foam structure collapses. Also, the conventional thermoset foamable underfill does not meet conventional first and second level assembly requirements. The present invention overcomes these conventional limitations. The present invention overcome the processing and assembly limitations described above and meets the requirements of lead-free assembly with high yield.

### SUMMARY OF THE INVENTION

The invention relates to a B-stageable or pre-formed underfill encapsulant composition that is used in the application of electronic components, most commonly chip scale packages (CSP's) to substrates. The invention is further compatible with the lead-free reflow process. The composition comprises an expandable filler material, thermoplastic resin, thermally cross-linkable resin, a latent catalyst which is preferably an imidazole acid salt, solvent, and optionally, fluxing agents and/or wetting agents. Various other additives, such as adhesion promoters, flow additives and rheology modifiers may also be added as desired. The underfill encapsulant may be B-stageable to provide a coating on the substrate or component that is smooth and non-tacky. In an alternative embodiment, the underfill encapsulant is a pre-formed film. In both embodiments the expandable filler material expands upon exposure to higher temperatures (lead-free solder reflow temperature) to form a closed-cell foam structure in the desired portion of the assembly. The underfill may be applied selectively to parts of the CSP, for example to the perimeter, as discrete dots between the solder bumps or in a grid pattern between the rows of solder bumps.

### BRIEF DESCRIPTION OF THE DRAWINGS

Figure 1 is a diagram of an assembly having foamable underfill before and after reflow.
Figure 2 is a diagram of an assembly having foamable underfill around its perimeter before and after reflow.
Figure 3 is a DSC curve of the thermally aged underfills.
Figure 4A is a cross section image of expandable underfill after one lead-free reflow exposure.
Figure 4B is a cross section image of expandable underfill after three lead-free reflow exposures.

### DETAILED DESCRIPTION OF THE INVENTION

The present invention relates to a formulation with suitable handling characteristics, processing characteristics and physical characteristics critical to package applied underfill for lead-free assembly. The composition of the present invention creates a dense closed cell foam structure around the package's solder balls, thereby improving the mechanical integrity of the solder joints, overall CSP reliability, and drop performance of the package. The polymer matrix of the present invention cross-links when subjected to lead-free reflow exposure, and this cross-linked network protects the expanded filler from collapsing during the higher temperature reflow conditions.

A preferred embodiment of the underfill encapsulant comprises at least one expandable filler material capable of expanding at elevated temperatures, a thermoplastic resin, a thermoset resin, a latent catalyst, and one or more solvents. Optionally, fluxing agents, air release agents, flow additives, adhesion promoters, rheology modifiers, surfactants, inorganic fillers and other ingredients may be included. The ingredients are specifically chosen to obtain the desired balance of properties for the use of the particular resins. A solvent is chosen to dissolve the resin(s) and thus make the composition into a paste form with proper viscosity for application as a liquid via spin coating, screen printing or stencil printing on the CSP panel. The underfill system may also be applied as a solid pre-formed laminated film.

The expandable fillers utilized in the underfill must be sufficient to produce a closed-cell foam that will fill the desired area. Frequently, the desired area is either the entire surface area surrounding the solder joints or a line around the perimeter of the assembly. A preferred expandable filler material is expandable thermoplastic micro balloons, such as are commercially available from Akzo Nobel (Sweden) as 098 DUX 120, 091 DU, 092 DU, and 095 DU. These microspheres are filled with isooctane and are stable at lower temperatures. The micro balloons do not expand at temperatures below 160°C, the temperature at which B-staging of the underfill occurs. Upon expansion, the microspheres create a closed-cell structure within the underfill matrix. Other materials that may be expected to provide the foam structure include chemical blowing agents.

Examples of thermoplastic resin suitable for use in the present underfill composition include high molecular weight phenoxy resins. Examples are thermoplastic resins available from Inchem under the trade names PKHC, PKHH, HC and HH, or blends of these with liquid epoxy resins.

The thermoset resin must be sufficiently cross-linked to lock the expanded cells in the matrix and protect them from collapse from high temperature. Cross-linking, as understood in the art, is the attachment of two-polymer chains by bridges of an element, a molecular group, or a compound, and in general takes place upon heating. Examples of the thermally cross-linkable resins are epoxy-based resins. The preferred epoxy-based resins are 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, bisphenol A epoxy resin, bisphenol F epoxy resin, epoxy novolac resin, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, and mixtures thereof.

The epoxy functionalities are catalyzed by a latent catalyst. The catalyst must sufficiently cross-link the themoset resin to lock the expanded cells in the matrix and protect them from collapse from high temperatures. Reactivity of the catalyst is important. The catalyst must have latency until 150°C because the material will first undergo B-staging. It has been unexpectedly determined that in order to provide the necessary benefits that the preferred latent catalyst is an imidazole acid salt.

A solvent is utilized to modify the viscosity of the composition. Preferably, the solvent will evaporate during the B-stage process which occurs at temperatures lower than about 150 °C or during the formation of the film. Common solvents that readily dissolve the epoxy and phenolic resins may be used. Examples of solvents that may be utilized include esters, alcohols, ethers, and other common solvents that are stable and dissolve the epoxy and phenolic resins in the composition. Preferred solvents include propylene glycol methyl ether acetate (PGMEA). Solvents that dissolve any part of the expandable microspheres should be avoided.

The expandable filler component of the underfill will comprise in the range of about 0.02 to about 10 wt % of the B-stageable composition and preferably about 0.1 to about 5 wt %. The thermoplastic component of the underfill will comprise in the range of about 10 to about 90 wt % of the B-stageable composition and preferably about 50 to about 90 wt %. The thermally cross-linkable resin component of the underfill will comprise in the range of about 1 to about 40 wt % of the B-stageable composition and preferably about 1 to about 15 wt %. The latent catalyst component of the underfill will comprise in the range of about 1 to about 15 wt % of the B-stageable composition and preferably about 1 to about 6 wt %. The solvent component of the underfill will comprise in the range of about 5 to about 80 wt % of the B-stageable composition and preferably about 30 to about 80 wt %. Finally, optional ingredients such as surfactants, air release agents, flow additives, rheology modifiers, chemical blowing agents and adhesion promoters may be added to the composition in the range of about 0.01 wt % to about 5 wt % of the B-stageable composition.

In a preferred embodiment, the composition is capable of an initial solidification that produces a smooth, non-tacky coating on the electronic component to be attached to a substrate. To utilize the composition containing the expandable fillers as a B-stageable liquid, the composition is applied directly onto a panel array of chips, or an individual chip via screen-printing, spin coating, stencil printing or dispensing through a needle between rows of solder bumps. The chip(s) or the coating is heated to an initial, B-stage temperature and the composition is B-stage solidified. The B-stage solidification preferably occurs at a temperature in the range of about 60°C to about 150 °C. Preferably, this heating results in a coating that is smooth and non-tacky and does not cause the expansion of the microspheres. After the B-stage process, a smooth, non-tacky solid coating is obtained on the CSP panel to ensure the clean dicing of the CSP panel into individual CSP_{S}. The thickness of the coating is preferably approximately 15 - 30% of the diameter of the solder bumps. Following the B-stage heating, the solder bumps may be plasma etched or wiped with solvent to facilitate component recognition in a placement machine. The chips having the B-staged composition are placed on a substrate with the solder bumps located on the metal pad connections. The use of solder paste or standard flux is required to maintain correct alignment of the component, as well as to facilitate the fluxing and solder joint formation. The final solidification occurs during exposure to the lead-free solder reflow temperature profile. For lead-free solder, the formation of the interconnections occurs at a temperature above the melting point of the solder, which is 217 °C. The entire assembly is heated under the lead-free reflow profile, a temperature of up to 245-255°C. This second heating causes the formation of interconnections between the substrate and the chip and allows the microspheres to expand and to fill the gap between the component and substrate.

In an alternative preferred embodiment, the composition is a pre-formed laminated film. To utilize the underfill encapsulant of the present invention as a laminated film, the film would be pre-cast on a carrier film and then dried or B-staged at a temperature below the expansion initiation temperature of the expandable filler. Next, the film would be vacuum laminated on to the full area of the component at the softening temperature of the film. Finally, the solder would be cleaned via plasma etching, or by wiping with solvent, and the component would be ready for placement. Alternatively, the film can be pre-patterned via varying methods such as laser ablation or die-cutting into different configurations such as a grid, mesh, thin strip, or square box pattern and placed or laminated onto the component. In this way, the contact between the solder bump and the underfill can be avoided and hence eliminate the need for plasma etching. After placement, the component is subjected to reflow which causes the expansion of the expandable fillers into the closed-cell structures. Both the B-stageable and laminated film applications require stencil printing of the solder paste before the component is placed.

In another embodiment, the present invention can meet the first and the second level assembly requirements in the lead-free reflow process. The first level assembly refers to the application of the underfill on the bumped CSP panels before it is diced into the individual CSPs. Once the components are diced into the individual CSPs, they are conditioned for up to 48 hours at 125°C as a part of burn-in conditions to remove moisture and ensure electrical performance. The present invention meets the requirements of the first level assembly by retaining 24-48 hour latency at 125°C; sustaining one year of storage stability at ambient condition; maintaining low moisture pickup during storage; and preserving 100% foaming/expansion functionality during the assembly. The second level assembly refers to the interconnection of the CSP to the PCB. The present invention meets the second level assembly under the lead-free reflow process by allowing 100% interconnection yield; improving thermal and mechanical reliability of solder joints; and retaining closed cell structure after three lead-free reflow exposures.

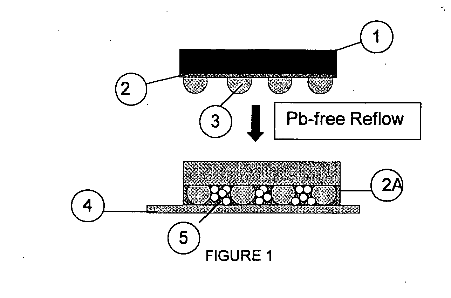

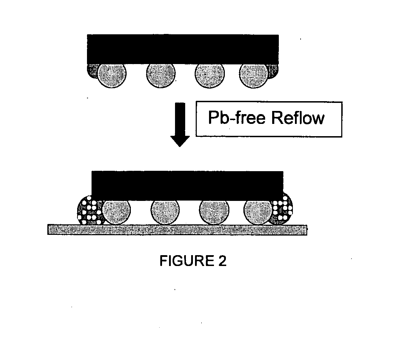

Figure 1 illustrates the expansion of the expandable fillers after reflow. Electrical component 1 is initially provided with a B-staged or film layer of underfill 2 and solder bumps 3. After reflow, the assembly of the electrical component and the substrate 4 has expanded underfill 2A that contains closed cell structures 5. In Figure 1 the underfill fills substantially all of the area in and around the solder bumps between the component and the substrate. Figure 2 illustrates an alternative underfill application in which the underfill 2 is applied to the perimeter of the component 1. The expanded underfill 2A is shown with the closed cell structures around the perimeter of the component after reflow.

The invention may be better understood by reference to the following examples:
EXAMPLE 1. Underfill compositions were manufactured as follows. A mixture of solvent and thermoplastic is added to a mixing vessel equipped with a propeller stirrer. The thermoset resin is then added to the vessel until dissolved. The expandable filler and catalyst are then added and mixed for 5 - 10 minutes until homogeneous. A surfactant is then added to facilitate vacuum removal of air bubbles. The mixture is de-gassed for 5 minutes in a vacuum chamber at a pressure of >28 in Hg. The formulations of the resulting underfills are shown in Table 1

**Table 1. Formulations**

| component | Formulation A (wt %) | Formulation B (wt %) |
|---|---|---|
| Expandable filler¹ | 2.00 | 2.00 |
| Thermoplastic resin ² | 85.67 | 89.76 |
| Thermoset resin³ | 9.52 | 8.00 |
| Latent catalyst⁴ | 2.57 | 0 |
| Addative⁵ | 0.24 | 0.24 |

| | | |
|---|---|---|
| ¹098 DUX 120, available from Akzo Nobel. | | |
| ²PKHS-30PMA, Phenoxy resin with propylene glycol methyl ether acetate blend, available from Inchem. | | |
| ³EPON 836, Epoxy resin, available from Resolution Performance Products | | |
| ⁴Vestogan B-68, Imidazole acid salt catalyst, available from Degussa. | | |
| ⁵ BYK A-500, Air-release additive, available from BYK Chemie | | |

Formulations were then applied onto chips and then B-staged at 125°C for 30 minutes. Both produced a smooth, non-tacky coating on the chip. Each formulation was then tested for pre-applied (first level) and lead-free CSP device (second level) assembly processes. To test the 24-48 hour latency at 125°C requirements, the B-staged Formulation A was subjected to thermal aging. After the underfills were thermally aged at 125°C, they were reflowed under the lead-free reflow process condition. The lead-free reflow condition consisted of 1:53 seconds at 160°C followed directly by 1:07 seconds at 260°C. The dry and reflowed film thickness values and percent expansions for the thermally aged materials are list in Table 2.

**Table 2. Effect of thermal aging at 125C on the foaming underfill**

| | Dry film thickness (mil) | reflowed film thickness (mil) | % Expansion |
|---|---|---|---|
| Formulation A 0 hrs | 1.55 | 4.25 | 174 |
| Formulation A 24 h rs | 1.88 | 5.35 | 185 |
| Formulation A 48 hrs | 1.48 | 4.72 | 219 |
| Formulation B 0 hrs | 2.0 | 2.5 | 25 |
| Formulation B 24 hrs | 1.5 | 2.3 | 53 |
| Formulation B 48 hrs | 1.8 | 2.4 | 33 |

As shown in Table 2, both the 24 and 48 hours of thermally aging showed similar level of expansion as the non-aged underfill for Formulation A. Formulation A is stable enough up to 48 hrs at 125°C to meet the processing conditions of level 1 assembly without sacrificing its performance at level 2 lead-free assembly. Conversely, Formulation B has minimal expansion after the reflow. Due to the lack of cross-linked matrix, the microballons collapsed under the lead-free reflow condition for Formulation B.

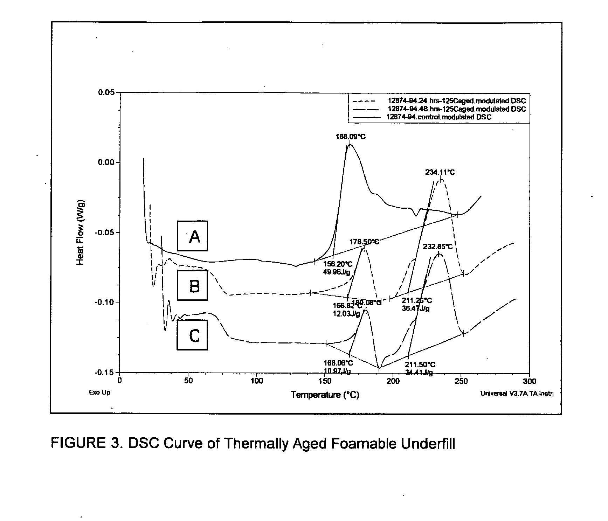

The performance properties of Formulation A showed all necessary characteristic to meet the first level assembly requirements. Results from storage stability, humidity exposure, and performance characteristics are listed in Table 3. Formulation A can also sustain 100% foaming/expansion functionality after 48 hrs. exposure to 125°C. As shown in the DSC curves in Figure 3, the materials exhibit reactivity even after thermally aging at 24 and 48 hours at 125°C. The DSC scans indicate that the enthalpy of both 24 hour (Figure 3, scan B) and 48 hour aged material (Figure 3, scan C) is similar to the un-aged material (Figure 3, scan A). Although Formulation A exhibits changes in the peak exotherm temperature, the materials are still reactive after thermal aging for 24-48 hours at 125°C.

**Table 3. Performance of Lead-Free Compatible Underfill with Expandable Filler for first level assembly**

| Performance Properties | Formulation A |
|---|---|
| Adhesion (CSP with solder to soldermask coated FR-4) (initial) | 14 ± 3 |
| Adhesion* (CSP with solder to soldermask coated FR-4) | 16 ± 2 |
| Melt T - DSC (initial) | 58.1 °C |
| Melt T* - DSC | 53.7°C |
| Storage Modulus by DMA @25C (initial) | 105 MPa |
| Storage Modulus by DMA** @25C | 92 MPa |
| Adhesion (solder mask to CBGA-36 dies @25C (initial) | 6.24 kg |
| Adhesion** (solder mask to CBGA-36 dies @25C | 8.47kg |
| Glass transition temperature | 93.6°C |

| | |
|---|---|
| * 168 hours of exposure at 60°C | |
| ** 7 days exposure at 85°C/85% relative humidity | |

The first level was then attached to the PCB for the second level assembly. The underfill material can also meet all of the second level assembly requirements. The material yielded 100% of interconnection under the lead-free solder reflow condition. Formulation A was also tested for thermal and mechanical reliability of the solder joints through drop test. As summarized in Table 4, the drop performance improved 3.2 times as compared to non-underfilled control. Hence, the present underfill improved the thermal and mechanical reliability of the solder joints.

**Table 4. Performance of Lead-Free Compatible Underfill with Expandable Filler for Second level assembly**

| Performance Properties | Value |
|---|---|
| Interconnection yield, Pb-free CSP on OSP-Cu/FR-4 | 100% |
| Drop Performance*** | 3.2 times compared to non-underfill control |
| Moisture Absorption**** | 1.9% |

| | |
|---|---|
| *** 2 meter height (60 mil FR-4 board, pBGA-169 component I/O 169, solder dia = 24 mil) | |
| ****10 days exposure at 85C/85% relative humidity | |

In order to study whether the underfill can maintain a closed cell structure after three lead-free reflow exposures, Formulation A was subjected to multiple lead-free reflow profiles to determine the degree of expansion. The dry and reflowed film thickness and the percent expansion are list in Table 5.

**Table 5. Effect of multiple lead-free reflow exposure on the foaming underfill**

| Number of reflow exposure | One | Two | Three |
|---|---|---|---|
| Dry film thickness (mil) | 1.8 | 5.12 | 5.12 |
| reflowed film thickness (mil) | 5.12 | 5.12 | 5 |
| % Expansion | 184 | 0 | -2.2 |

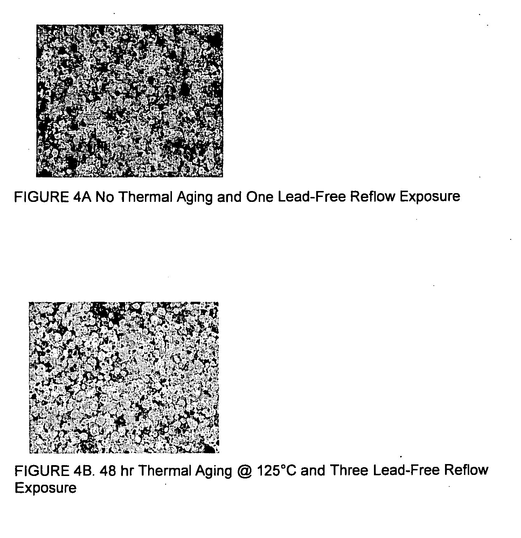

As shown in Table 5, the expanded film maintained its integrity during the second and third lead-free reflow profiles. Figure 4B shows that the cells maintain their closed structure even after three lead-free reflow exposures. The present invention can meet all of the 1^{st} and the 2^{nd} level assembly requirements under the lead-free reflow conditions.

Many modifications and variations of this invention can be made without departing from its spirit and scope, as will be apparent to those skilled in the art. The specific embodiments described herein are offered by way of example only, and the invention is to be limited only by the terms of the appended claims, along with the full scope of equivalents to which such claims are entitled.

## Claims

1. A lead-free compatible and expandable underfill encapsulant comprising
a) one or more expandable fillers;
b) a thermoplastic polymer resin;
c) a thermosetting resin
d) a latent catalyst comprising at least one imidazole acid salt; and
e) at least one solvent.

2. The encapsulant of claim 1, wherein the one or more expandable filler is selected from the group comprising microspheres, expandable balloons, and mixtures thereof.

3. The encapsulant of claim 2, wherein the one or more expandable fillers comprises in the range of about 0.02 wt % to about 10 wt % of the encapsulant.

4. The encapsulant of claim 3, wherein the one or more expandable fillers comprises in the range of about 0.1 wt % to about 5 wt % of the encapsulant.

5. The encapsulant of claim 2, wherein the one or more expandable fillers expand upon exposure to temperatures greater than about 150°C.

6. The encapsulant of claim 1, wherein the encapsulant is B-stageable.

7. The encapsulant of claim 6, wherein the encapsulant is a B-stable paste, pre-patterned paste, pre-formed laminated film, pre-patterned film or film.

8. The encapsulant of claim 7, wherein the encapsulant is capable of pre-application on an electronic component or substrate.

9. The encapsulant of claim 8, wherein the encapsulant is capable of application on an electronic component via screen-printing, spin coating, stencil printing or dispensing through a needle.

10. The encapsulant of claim 1, wherein the thermoplastic resin is a chain extended epoxy resin selected phenoxy resin.

11. The encapsulant of claim 10, wherein the thermoplastic resin comprises in the range of about 10 wt % to about 90 wt % of the encapsulant.

12. The encapsulant of claim 11, wherein the thermoplastic resin comprises in the range of about 50 wt % to about 90 wt % of the encapsulant.

13. The encapsulant of claim 1, wherein the thermoset resin is selected from the group consisting of 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, bisphenol A epoxy resin, bisphenol F epoxy resin, epoxy novolac resin, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, and mixtures thereof.

14. The encapsulant of claim 13, wherein the thermoset resin comprises in the range of about 1 wt % to about 40 wt % of the encapsulant.

15. The encapsulant of claim 14, wherein the thermoset resin comprises in the range of about 1 wt % to about 15 wt % of the encapsulant.

16. The encapsulant of claim 1, wherein the catalyst comprises in the range of about 1 wt % to about 15 wt % of the encapsulant.

17. The encapsulant of claim 16, wherein the catalyst comprises in the range of about 1 wt % to about 6 wt % of the encapsulant.

18. The encapsulant of claim 1, wherein at least one solvent is selected from the group comprising solvents that are stable and dissolve the thermoplastic and/or thermoset resins in the composition.

19. The encapsulant of claim 18, wherein at least one solvent is selected from the group comprising esters, alcohols, ethers and propylene glycol methyl ether acetate and mixtures thereof.

20. The encapsulant of claim 19, wherein the at least one solvent comprises propylene glycol methyl ether acetate and mixtures thereof.

21. The encapsulant of claim 18, wherein the solvent comprises in up to about 80 wt % of the encapsulant.

22. The encapsulant of claim 1, wherein the encapsulant further comprises one or more of group consisting of surfactants, coupling agents, reactive diluents, air release agents, flow additives, adhesion promoters, inorganic fillers and mixtures thereof.

23. The encapsulant of claim 22, wherein the surfactants, coupling agents, reactive diluents, air release agents, flow additives, adhesion promoters, inorganic fillers comprises in the range of about 0.01 wt % to about 5 wt % of the encapsulant.

24. The encapsulant of claim 22 wherein the surfactant is selected from the group consisting of organic acrylic polymers, silicones, epoxy silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures thereof.

25. An electronic component having the expandable underfill composition of claim 1.

26. The electronic component of claim 24, wherein the underfill B-stages to form a smooth, non-tacky coating on the electronic component.
